# EUROPEAN PATENT APPLICATION

(11) **EP 4 750 264 A1**
(43) Date of publication of application: **27.05.2026**
(21) Application number: 24855511.2
(22) Date of filing: 09.07.2024
(51) Int. Cl.: H10F 10/00

(54) **BATTERY STRING AND PHOTOVOLTAIC MODULE**

(30) Priority: 22.08.2023 CN 202311061413
(71) Applicant: Longi Green Energy Technology Co., Ltd., Xi'an, Shaanxi 710100 (CN)
(72) Inventor: LI, Zhenguo, Xi' an, Shaanxi 710100 (CN); ZHAI, Weixin, Xi' an, Shaanxi 710100 (CN); ZHANG, Liang, Xi' an, Shaanxi 710100 (CN); YU, Yonglin, Xi' an, Shaanxi 710100 (CN); FENG, Chunnuan, Xi' an, Shaanxi 710100 (CN); LYU, Jun, Xi' an, Shaanxi 710100 (CN)
(74) Representative: Grünecker Patent- und Rechtsanwälte PartG mbB
(86) International application number: PCT/CN2024/104543
(87) International publication number: WO 2025/039782

(57) **Abstract**

The present application relates to the field of photovoltaic module technologies, and specifically to a cell string and a photovoltaic module. The cell string includes a first connection line, a first cell, and a second cell, the first cell and the second cell being electrically connected by the first connection line. The first connection line extends along a first direction on a first surface of the first cell. The first cell is provided with a first edge and a second edge that are opposite in the first direction. A first terminal line extending along the first direction is disposed on the first surface of the first cell. The first terminal line is close to the first edge and away from the second edge. A portion of the first connection line extends onto the first terminal line to form an overlapping portion. A ratio of a length of the overlapping portion to a length of the first terminal line is less than or equal to 80%.

## Description

The present application claims priority to Chinese patent application No. 202311061413.6, entitled "CELL STRING AND PHOTOVOLTAIC MODULE", filed with the China National Intellectual Property Administration on August 22, 2023, the disclosure of which is hereby incorporated by reference in its entirety.

### TECHNICAL FIELD

The present application relates to the field of photovoltaic module technologies, and in particular, to a cell string and a photovoltaic module.

### BACKGROUND

As a core component of a photovoltaic module, a cell string can convert solar energy into electrical energy. Typically, a cell string includes a plurality of cells arranged in sequence. A busbar and a finger are disposed on the surface of each cell. The fingers collect the current generated by the cells. The busbars are interconnected with the fingers. The busbars converge the current collected by the fingers, thereby aggregating the current generated by the cells.

During the processing of cell strings, paste is typically printed on the surface of a cell through screen printing to form a plurality of fingers and a plurality of busbars that are perpendicular to each other on the surface of the cell. The plurality of fingers and the plurality of busbars collect and aggregate the current generated by the cell, aiming to collect the current generated by the entire cell. However, the arrangement of the plurality of busbars and the plurality of fingers on the surface of the cell needs to consume a significant amount of paste, which consequently increases the costs of the cell. Additionally, the fingers and the busbars obstruct the upper surface of the cell, reducing the efficiency of absorbing light by the upper surface of the cell, thereby affecting the photoelectric conversion efficiency of the cell.

In the related art, to reduce the production costs of a cell while enhancing the photoelectric conversion efficiency of the cell, only fingers are disposed on the surface of the cell. Solder ribbons are disposed at the positions of busbars, and the fingers are connected by the solder ribbons to aggregate the current collected by the fingers.

However, the solder ribbons cannot cover the entire surface of the cell in the extension direction of the solder ribbons. As a result, fingers on two sides on the surface of the cell cannot be connected to the solder ribbons in the extension direction of the solder ribbons. Consequently, the current collected by some fingers fails to be converged onto the solder ribbons, thereby affecting the photoelectric conversion efficiency of the cell.

### SUMMARY

An objective of the present application is to provide a cell string and a photovoltaic module.

Specifically, the present application involves the following aspects:
According to a first aspect, the present application discloses a cell string, including a first connection line, a first cell, and a second cell, the first cell and the second cell being electrically connected by the first connection line. The first connection line extends along a first direction on a first surface of the first cell. The first cell is provided with a first edge and a second edge that are opposite in the first direction. A first terminal line extending along the first direction is disposed on the first surface of the first cell. The first terminal line is close to the first edge and away from the second edge. A portion of the first connection line extends onto the first terminal line to form an overlapping portion. A ratio of a length of the overlapping portion to a length of the first terminal line is less than or equal to 80%.

In some embodiments, the length of the overlapping portion accounts for 40% to 80% of the length of the first terminal line.

In some embodiments, a plurality of first connection lines and a plurality of first terminal lines are provided, and the first connection lines and the first terminal lines are disposed in a one-to-one correspondence.

In some embodiments, a plurality of fingers that extend along a second direction and are disposed at intervals in the first direction are further disposed on the first surface of the first cell, and the second direction intersects the first direction; and the first terminal line is only connected to some of the plurality of fingers close to the first edge, and the first terminal line is connected to a finger closest to the first edge.

In some embodiments, a bonding layer is provided on the first connection line, and the first connection line is at least connected to some of the fingers by the bonding layer.

In some embodiments, the first connection line is fixed to the first surface of the first cell by a plurality of discrete adhesive dots.

In some embodiments, the length of the first terminal line is less than 1/4 of a length of a projection of the first connection line onto the first cell.

In some embodiments, the first surface of the first cell further includes a second terminal line close to the second edge, and the second terminal line is entirely covered by the first connection line.

In some embodiments, in the first direction, a distance between an end portion of the first connection line and the first edge of the first cell is greater than or equal to 3 mm and less than or equal to 8.75 mm.

In some embodiments, only one adhesive dot is disposed on the overlapping portion, and the adhesive dot is a first adhesive dot; in the first direction, a distance between the first adhesive dot and the first edge is a third distance, and a distance between an end portion of the first connection line and the first edge is a fourth distance; and a difference between the third distance and the fourth distance is greater than or equal to 2 mm.

In some embodiments, in a second direction, lengths of the first cell and the second cell are greater than or equal to 180 mm and less than or equal to 240 mm.

In some embodiments, dimensions of the first cell and the second cell include: (182±2) mm*(96±1) mm, (192±2) mm*(91±1) mm, (182±2) mm*(91±1) mm, and (182±2) mm*(105±1) mm.

According to a second aspect, the present application discloses a cell string, including a first connection line, a first cell, and a second cell, the first cell and the second cell being electrically connected by the first connection line. The first connection line is fixed to a first surface of the first cell by a plurality of discrete adhesive dots. The first connection line extends along a first direction. The first cell is provided with a first edge and a second edge that are opposite in the first direction. A first terminal line extending along the first direction is disposed on the first surface of the first cell. The first terminal line is close to the first edge and away from the second edge. A portion of the first connection line extends onto the first terminal line to form an overlapping portion. Only one adhesive dot is disposed on the overlapping portion. The adhesive dot is a first adhesive dot. A distance between the first adhesive dot and an end portion of the first terminal line close to the first edge is a first distance. A distance between the first adhesive dot and an end portion of the first terminal line away from the first edge is a second distance. A ratio of the first distance to the second distance ranges from 1:5 to 2:1.

In some embodiments, the first surface of the first cell further includes a second terminal line close to the second edge, and the second terminal line is entirely covered by the first connection line.

In some embodiments, at least one adhesive dot is disposed on the second terminal line.

In some embodiments, two ends of the first terminal line are connected to two fingers, respectively, a first bold section is disposed at a connection to each of the two fingers, and the first terminal line is electrically connected to the fingers by the first bold section.

In some embodiments, the first cell further includes a second surface disposed opposite to the first surface, and the cell string further includes a second connection line connected to the second surface; the second connection line is connected to the second surface of the first cell by a plurality of discrete adhesive dots; and projections of the plurality of adhesive dots on the first surface onto the first cell are disposed in a staggered manner from projections of the plurality of adhesive dots on the second surface onto the first cell.

In some embodiments, in the first direction, a distance between the first adhesive dot and the first edge is a third distance, and a distance between an end portion of the first connection line and the first edge is a fourth distance; and a difference between the third distance and the fourth distance is greater than or equal to 2 mm.

According to a third aspect, the present application discloses a photovoltaic module, including a cover plate, a first adhesive layer, a plurality of cell strings in the first aspect or the second aspect, a second adhesive layer, and a back sheet that are disposed in sequence. The plurality of cell strings are arranged at intervals.

The present application provides a cell string and a photovoltaic module. The cell string includes a first connection line, a first cell, and a second cell, the first cell and the second cell being electrically connected by the first connection line. The first connection line extends along a first direction on a first surface of the first cell. The first cell is provided with a first edge and a second edge that are opposite in the first direction. A first terminal line extending along the first direction is disposed on the first surface of the first cell. The first terminal line is close to the first edge and away from the second edge. A portion of the first connection line extends onto the first terminal line to form an overlapping portion. A ratio of a length of the overlapping portion to a length of the first terminal line is less than or equal to 80%. In the cell string in the embodiments of the present application, the first terminal line extending along the first direction is disposed on the first surface of the first cell, and the first terminal line is close to the first edge of the first cell and away from the second edge. The first connection line extends along the first direction on the first surface of the first cell. A portion of the first connection line extends onto the first terminal line to form an overlapping portion. A ratio of a length of the overlapping portion to a length of the first terminal line is less than or equal to 80%. Therefore, the current generated in a region of the first cell close to the first edge may be collected using the first terminal line, thereby improving the photoelectric conversion efficiency of the cell.

Further, through the foregoing arrangement, the current collected by the fingers around the first edge can be sufficiently converged, and it can be ensured that the first connection line does not extend out of the first edge of the first cell, there avoiding a short circuit in the cell string.

The above description is only an overview of the technical solutions of the present application. For a clearer understanding of the technical measure of the present application and implementation according to the content of the specification, and to make the above and other objectives, features, and advantages of the present application clearer and more comprehensible, specific embodiments of the present application are described below.

### BRIEF DESCRIPTION OF THE DRAWINGS

To describe the technical solutions in embodiments of the present application or the related art more clearly, the following briefly introduces the accompanying drawings required for describing the embodiments or the related art. Apparently, the accompanying drawings in the following description show some embodiments of the present application, and a person of ordinary skill in the art may still derive other drawings from these accompanying drawings without creative efforts.
FIG. 1 is a schematic structural diagram 1 of a first surface of a first cell according to an embodiment of the present application;
FIG. 2 is a partial enlarged view A-A of a first cell according to an embodiment of the present application;
FIG. 3 is a schematic structural diagram 2 of a first surface of a first cell according to an embodiment of the present application;
FIG. 4 is a partial enlarged view B-B of a first cell according to an embodiment of the present application;
FIG. 5 is a schematic structural diagram of a first bold section according to an embodiment of the present application;
FIG. 6 is a schematic structural diagram of a second surface of a first cell according to an embodiment of the present application;
FIG. 7 is a cross-sectional view 1 of a photovoltaic module according to an embodiment of the present application; and
FIG. 8 is a cross-sectional view 2 of a photovoltaic module according to an embodiment of the present application.

Reference numerals:
10: first cell; 11: first surface; 12: second surface; 13: first edge; 14: second edge;
20: finger;
30: first connection line; 31: bonding layer;
40: first terminal line; 41: second terminal line;
50: adhesive dot; 51: first adhesive dot;
60: first bold section;
70: cover plate; 71: first adhesive layer; 711: EVA layer; 712: POE layer;
K: first direction; H: second direction.

### DETAILED DESCRIPTION

To make the objectives, technical solutions, and advantages of embodiments of the present application clearer, the following clearly and completely describes the technical solutions in embodiments of the present application with reference to the accompanying drawings in embodiments of the present application. It is clear that the described embodiments are merely some rather than all of embodiments of the present application. All other embodiments obtained by a person of ordinary skill in the art based on the embodiments of the present application without creative efforts fall within the protection scope of the present application.

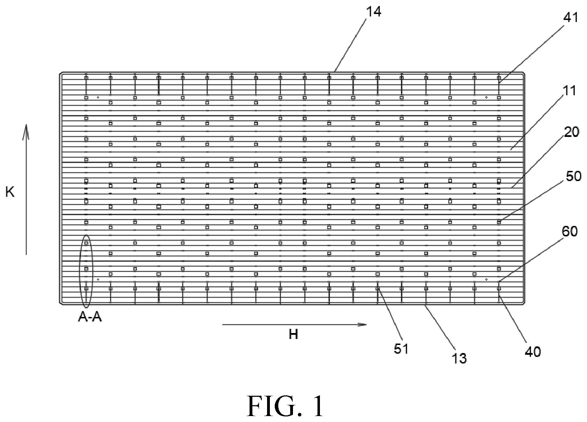

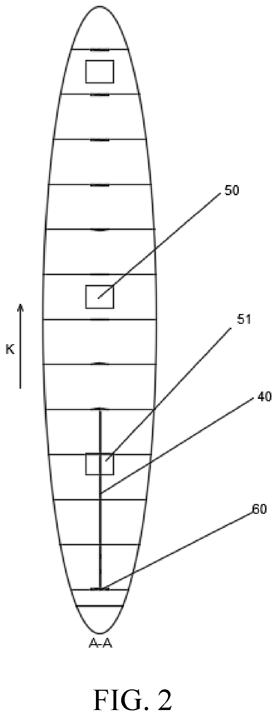

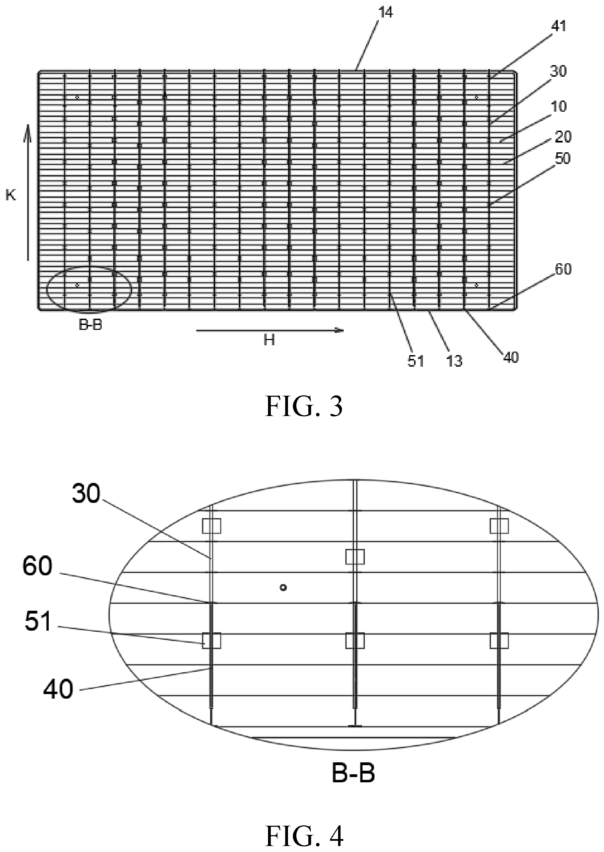

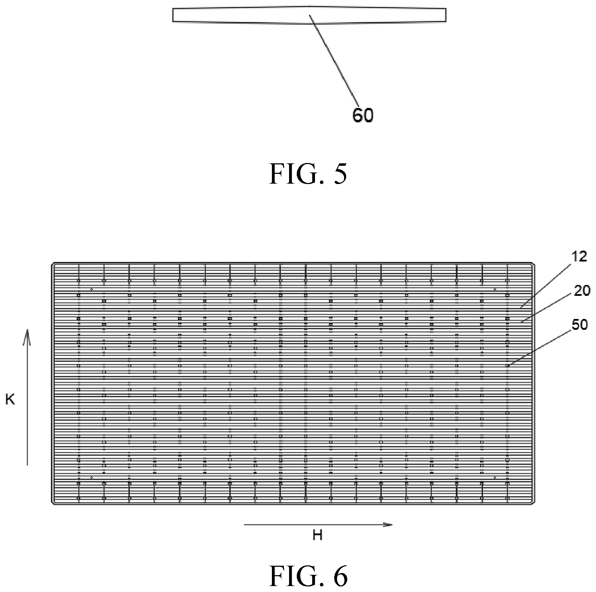

FIG. 1 is a schematic structural diagram 1 of a first surface of a first cell according to an embodiment of the present application. FIG. 2 is a partial enlarged view A-A of a first cell according to an embodiment of the present application. FIG. 3 is a schematic structural diagram 2 of a first surface of a first cell according to an embodiment of the present application. FIG. 4 is a partial enlarged view B-B of a first cell according to an embodiment of the present application. FIG. 5 is a schematic structural diagram of a first bold section according to an embodiment of the present application. FIG. 6 is a schematic structural diagram of a second surface of a first cell according to an embodiment of the present application.

As shown in FIG. 1 to FIG. 4, embodiments of the present application provide a cell string. The cell string includes a first connection line 30, a first cell 10, and a second cell, the first cell 10 and the second cell being electrically connected by the first connection line 30. The first connection line 30 extends along a first direction K on a first surface 11 of the first cell 10. The first cell 10 is provided with a first edge 13 and a second edge 14 that are opposite in the first direction K. A first terminal line 40 extending along the first direction K is disposed on the first surface 11 of the first cell 10. The first terminal line 40 is close to the first edge 13 and away from the second edge 14. A portion of the first connection line 30 extends onto the first terminal line 40 to form an overlapping portion. A ratio of a length of the overlapping portion to a length of the first terminal line 40 is less than or equal to 80%. In this way, sufficient current collection can be performed on the finger at the edges, and it can be ensured that solder ribbons are kept from extending out of the edges of the cells to avoid a short circuit. In some embodiments, the length of the overlapping portion accounts for 40% to 80% of the length of the first terminal line 40.

In the cell string disclosed in the embodiments of the present application, the first terminal line 40 extending along the first direction K is disposed on the first surface 11 of the first cell 10, and the first terminal line 40 is close to the first edge 13 of the first cell 10 and away from the second edge 14. The first connection line 30 extends along the first direction K on the first surface 11 of the first cell 10. A portion of the first connection line 30 extends onto the first terminal line 40 to form an overlapping portion. A ratio of a length of the overlapping portion to a length of the first terminal line 40 is less than or equal to 80%. Therefore, the current generated in a region of the first cell 10 close to the first edge 13 may be collected using the first terminal line 40, thereby improving the photoelectric conversion efficiency of the cell. Further, through the foregoing arrangement, the current collected by the fingers 20 around the first edge 13 can be sufficiently converged, and it can be ensured that the first connection line 30 does not extend out of the first edge 13 of the first cell 10, thereby avoiding a short circuit in the cell string.

In some embodiments, the length of the overlapping portion accounts for 40% to 80% of the length of the first terminal line 40.

Embodiments of the present application provide a cell string. The cell string includes a first cell 10 and a second cell that are spaced apart. A first gap exists between the first cell 10 and the second cell. Each of the first cell 10 and the second cell includes a first surface and a second surface that are oppositely disposed, and the first surface 11 of the first cell 10 and the first surface of the second cell are disposed facing the same direction.

The first cell 10 is provided with a first edge 13 and a second edge 14 that are opposite in a first direction K. A first terminal line 40 extending along the first direction K is disposed on the first surface 11 of the first cell 10. The first terminal line 40 is close to the first edge 13 and away from the second edge 14.

As shown in FIG. 3, the first connection line 30 extends along the first direction K on the first surface 11 of the first cell 10. A portion of the first connection line 30 extends onto the first terminal line 40 and form an overlapping portion with the first terminal line 40. A length of the overlapping portion accounts for 40% to 80% of a length of the first terminal line 40. The other end of the first connection line 30 extends to the second edge 14 of the first cell 10, passes through the first gap, and is connected to the second surface of the second cell. Therefore, the first cell 10 and the second cell are electrically connected by the first connection line 30.

For example, the length of the overlapping portion of the first connection line 30 and the first terminal line 40 may account for 40%, 50%, 60%, 70%, 80%, or the like of the length of the first terminal line 40. This is not specifically limited in the present application, and may be set by a skilled person as required during actual use.

It should be noted that the first connection line 30 and the first terminal line 40 in the embodiments of the present application both have the property of being electrically conductive. The first connection line 30 may be a solder ribbon, a soldering rod, or the like. In addition, metal paste may be printed on a side of the first surface 11 of the first cell 10 close to the first edge 13 through screen printing to form the first terminal line 40 on the first surface 11 of the first cell 10.

Certainly, the foregoing is merely an example of the first connection line 30 and a forming manner of the first terminal line 40, and is not used as a limitation to the present application. During actual use, a skilled person may select a suitable first connection line 30 as required, and also select a suitable manner as required to arrange the first terminal line 40 on the first surface 11 of the first cell 10.

In the cell string provided in the embodiments of the present application, the first terminal line 40 extending along the first direction K is disposed on the first surface 11 of the first cell 10, and the first terminal line 40 is close to the first edge 13 of the first cell 10 and away from the second edge 14. The first connection line 30 extends along the first direction K on the first surface 11 of the first cell 10. A portion of the first connection line 30 extends onto the first terminal line 40 to form an overlapping portion. A length of the overlapping portion accounts for 40% to 80% of a length of the first terminal line 40. Therefore, the current generated in a region of the first cell 10 close to the first edge 13 may be collected using the first terminal line 40, thereby improving the photoelectric conversion efficiency of the cell.

In some embodiments, as shown in FIG. 1 and FIG. 3, a plurality of first connection lines 30 and a plurality of first terminal lines 40 are provided, and the first connection lines 30 and the first terminal lines 40 are disposed in a one-to-one correspondence.

In the embodiments of the present application, as shown in FIG. 1 and FIG. 3, the plurality of first connection lines 30 and the plurality of first terminal lines 40 are provided, and each first connection line 30 is disposed corresponding to one first terminal line 40. The current generated in a region of the first cell 10 close to the first edge 13 is collected using the plurality of first terminal lines 40, and the collected current is conducted to the corresponding first connection lines 30.

In some embodiments, as shown in FIG. 1 to FIG. 4, a plurality of fingers 20 that extend along a second direction H and are disposed at intervals in the first direction K are further disposed on the first surface 11 of the first cell 10, and the second direction H intersects the first direction K; and the first terminal line 40 is only connected to some of the plurality of fingers 20 close to the first edge 13, and the first terminal line 40 is connected to a finger 20 closest to the first edge 13.

In the embodiments of the present application, as shown in FIG. 1 to FIG. 4, the plurality of fingers 20 that extend along the second direction H and are disposed at intervals in the first direction K are further disposed on the first surface 11 of the first cell 10. The current generated by the first surface 11 of the first cell 10 may be collected using the plurality of fingers 20.

The second direction H intersects the first direction K. Specifically, the second direction H may be perpendicular to the first direction K. That is, each first connection line 30 is cross-connected to the plurality of fingers 20, so that the current generated by the plurality of fingers 20 may be converged using the first connection line 30, thereby converging the current generated by the first surface 11 of the first cell 10.

To prevent the first connection line 30 from being electrically connected to another connection line to avoid causing a short circuit in the cell string, a gap exists between the first connection line 30 and the first edge 13 of the first surface 11 of the first cell 10. The first connection line 30 cannot extend to the first edge 13 of the first surface 11 of the first cell 10. Therefore, the plurality of first terminal lines 40 are disposed on a side of the first surface 11 of the first cell 10 close to the first edge 13. The first terminal lines 40 is connected to some of the fingers 20 close to the first edge 13, and the first terminal lines 40 are connected to a finger 20 closest to the first edge 13, to converge, using the first terminal lines 40, the current generated by the some fingers 20 close to the first edge 13. In addition, the converged current is conducted to the corresponding first connection lines 30, thereby improving the photoelectric conversion efficiency of the cell.

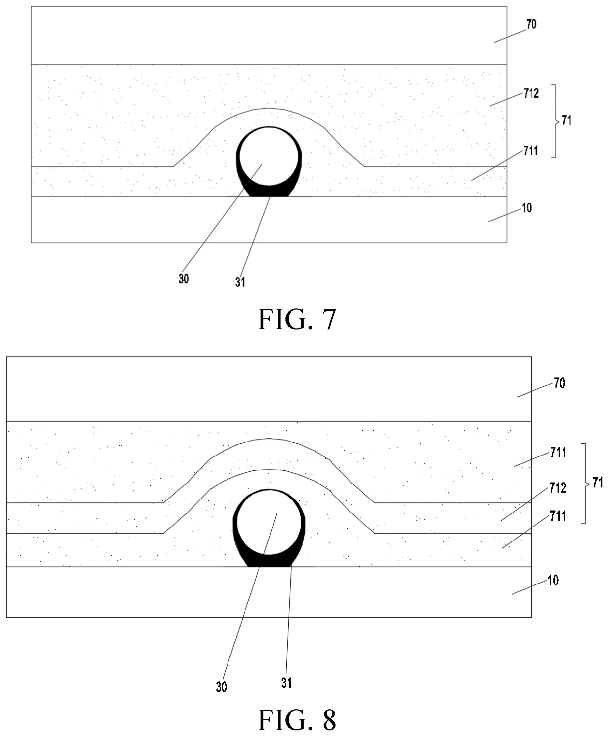

In some embodiments, as shown in FIG. 7, a bonding layer 31 is provided on the first connection line 30, and the first connection line 30 is connected to at least some of the fingers 20 by the bonding layer 31.

In the embodiments of the present application, as shown in FIG. 7, the bonding layer 31 is provided on the first connection line 30. The bonding layer 31 is electrically conductive. The first connection line 30 is at least connected to some of the fingers 20 by the bonding layer 31, so that the some fingers 20 are electrically connected to the first connection line 30, and the current collected by the some fingers 20 is converged using the first connection line 30.

For example, when the first connection line 30 is a solder ribbon, the bonding layer 31 may be a tin layer. The solder ribbon is connected to at least the tin layer through the tin layer.

Certainly, in the embodiments of the present application, the first connection line 30 and the bonding layer 31 are not specifically limited. During actual use, a skilled person may select a suitable first connection line 30 and a suitable bonding layer 31 as required.

In some embodiments, as shown in FIG. 1 and FIG. 3, the first connection line 30 is fixed to the first surface 11 of the first cell 10 by a plurality of discrete adhesive dots 50.

In the embodiments of the present application, as shown in FIG. 1 and FIG. 3, the plurality of adhesive dots 50 are disposed on the first surface 11 of the first cell 10 at intervals along the first direction K, and each adhesive dot 50 is at least partially disposed between two adjacent fingers 20, so that one first connection line 30 is fixed to the first surface 11 of the first cell 10 by the plurality of adhesive dots 50.

It should be noted that the plurality of first connection lines 30 in the embodiments of the present application may be fixed to the first surface of the first cell 10 in the foregoing manner, thereby forming the plurality of discrete adhesive dots 50 on the first surface 11 of the first cell 10.

In some embodiments, as shown in FIG. 1 and FIG. 3, the length of the first terminal line 40 is less than 1/4 of a length of a projection of the first connection line 30 onto the first cell 10.

Typically, the first terminal line 40 is formed by printing metal paste on a side of the first surface 11 of the first cell 10 close to the first edge 13 through screen printing. Therefore, in the embodiments of the present application, as shown in FIG. 1 and FIG. 3, the length of the first terminal line 40 is set to be less than 1/4 of the length of the projection of the first connection line 30 onto the first cell 10. In this way, the usage of metal paste is reduced, and the production costs of the cell string is reduced.

For example, the length of the first terminal line 40 may be set to 1/5 of the length of the projection of the first connection line 30 onto the first cell 10, or the length of the first terminal line 40 may be set to 1/6 of the length of the projection of the first connection line 30 onto the first cell 10. This is not specifically limited in the present application, and may be set by a skilled person as required during actual use.

In some embodiments, as shown in FIG. 1 to FIG. 4, only one adhesive dot 50 is disposed on the overlapping portion, and the adhesive dot 50 is a first adhesive dot 51.

In the embodiments of the present application, as shown in FIG. 1 to FIG. 4, only one adhesive dot 50 is disposed on the overlapping portion of the first connection line 30 and the first terminal line 40, and the adhesive dot 50 is a first adhesive dot 51. One end of the first connection line 30 is adhered to a side of the first surface 11 of the first cell 10 close to the first edge 13 using the first adhesive dot 51, and partially overlaps the first terminal line 40. One end of the first connection line 30 is fixed by the first adhesive dot 51, and the first connection line 30 is electrically connected to the first terminal line 40.

In some embodiments, as shown in FIG. 3 and FIG. 4, a distance between the first adhesive dot 51 and an end portion of the first terminal line 40 close to the first edge 13 is a first distance, a distance between the first adhesive dot 51 and an end portion of the first terminal line 40 away from the first edge 13 is a second distance, and a ratio of the first distance to the second distance ranges from 1:5 to 2:1.

As shown in FIG. 3 and FIG. 4, in the embodiments of the present application, the distance between the first adhesive dot 51 and the end portion of the first terminal line 40 close to the first edge 13 is set as the first distance, the distance between the first adhesive dot 51 and the end portion of the first terminal line 40 away from the first edge 13 is set as the second distance, and the ratio of the first distance to the second distance is set to range from 1:5 to 2:1. For example, the ratio of the first distance to the second distance may be 1:4, 1:3, 1:2, 1:1, 3:2, 8:5, 2:1, or the like.

It should be noted that in a direction perpendicular to a plane in which the first cell 10 is located, the first adhesive dot 51 may be circular, or may be square, rectangular, or the like. For example, when the first adhesive dot 51 is circular, a diameter of the first adhesive dot 51 may be 1.1 mm. The first distance is a distance between the center of circle of the first adhesive dot 51 and the end portion of the first terminal line 40 close to the first edge 13, and the second distance is a distance between the center of circle of the first adhesive dot 51 and the end portion of the first terminal line 40 away from the first edge 13.

When the first adhesive dot 51 is rectangular, the dimension of the first adhesive dot 51 may be 1 mm*1.2 mm. The first distance is a distance between the center of the first adhesive dot 51 and the end portion of the first terminal line 40 close to the first edge 13, and the second distance is a distance between the center of the first adhesive dot 51 and the end portion of the first terminal line 40 away from the first edge 13.

In some embodiments, as shown in FIG. 1 and FIG. 3, the first surface 11 of the first cell further 10 includes a second terminal line 41 close to the second edge 14, and the second terminal line 41 is entirely covered by the first connection line 30.

As shown in FIG. 1 and FIG. 3, in the embodiments of the present application, the second terminal line 41 is disposed on a side of the first surface 11 of the first cell 10 close to the second edge 14. The second terminal line 41 extends along the first direction K, and the second terminal line 41 extends to a finger 20 closest to the second edge 14. Therefore, the current collected by the fingers 20 in a region of the first surface 11 of the first cell 10 close to the second edge 14 may be converged using the second terminal line 41.

The second terminal line 41 is entirely covered by the first connection line 30. That is, the second terminal line 41 is connected to the first connection line 30, so that the current collected by the second terminal line 41 may be conducted to the first connection line 30.

It should be noted that the second terminal line 41 in the embodiments of the present application is electrically conductive. Metal paste may be printed on a side of the first surface 11 of the first cell 10 close to the second edge 14 through screen printing to form the second terminal line 41 on the first surface 11 of the first cell 10. In some embodiments, as shown in FIG. 1, at least one adhesive dot 50 is disposed on the second terminal line 41.

As shown in FIG. 1, in the embodiments of the present application, at least one adhesive dot 50 is disposed on the second terminal line 41 to fix the first connection line 30 to the second terminal line 41 by the at least one adhesive dot 50, so that the first connection line 30 covers the second terminal line 41.

In some embodiments, as shown in FIG. 2, two ends of the first terminal line 40 are connected to two fingers 20, respectively, a first bold section 60 is disposed at a connection to each of the two fingers 20, and the first terminal line 40 is electrically connected to the fingers 20 by the first bold section 60.

As shown in FIG. 2, in the embodiments of the present application, the two ends of the first terminal line 40 are connected to the two fingers 20, respectively, and the first bold section 60 is disposed at the connection between each of the two ends of the first terminal line 40 and one of the fingers 20, so that each of the two ends of the first terminal line 40 is electrically connected to one of the fingers 20 by one first bold section 60. The reliability of the connections between the two ends of the first terminal line 40 and the fingers 20 is improved.

It should be noted that the first bold section 60 in the embodiments of the present application is electrically conductive. Metal paste may be printed on the connections between the end portions of the first terminal line 40 and the fingers 20 through screen printing to form the first bold section 60 at the connections between the end portions of the first terminal line 40 and the fingers 20.

As shown in FIG. 5, the first bold section 60 may be a structure that is thick in the middle and narrow at two ends. Certainly, the first bold section 60 may alternatively be another structure. In the embodiments of the present application, a specific structure of the first bold section 60 is not excessively limited, and may be set by a skilled person as required during actual use.

In some embodiments, as shown in FIG. 7, the first cell 10 further includes a second surface 12 disposed opposite to the first surface 11, and the cell string further includes a second connection line connected to the second surface 12. The first connection line 30 and the second connection line are connected to the first surface 11 and the second surface 12 of the first cell 10 by a plurality of adhesive dots 50, respectively. Projections of the plurality of adhesive dots 50 on the first surface 11 onto the first cell 10 are disposed in a staggered manner from projections of the plurality of adhesive dots 50 on the second surface 12 onto the first cell 10.

In the embodiments of the present application, as shown in FIG. 7, a plurality of second connection lines are connected to the second surface 12 of the first cell 10. The plurality of second connection lines extend along the first direction K and are adhered to the second surface 12 of the first cell 10 by the plurality of adhesive dots 50.

As shown in FIG. 3, the plurality of first connection lines 30 are connected to the first surface 11 of the first cell 10. The plurality of first connection lines 30 extend along the first direction K, and are adhered to the first surface 11 of the first cell 10 by the plurality of adhesive dots 50.

During the processing of the cell string, the plurality of adhesive dots 50 may be first printed on the first surface 11 of the first cell 10, and then the plurality of adhesive dots 50 are printed on the second surface 12 of the first cell 10. During printing, because the first surface 11 of the first cell 10 is not supported, to avoid the plurality of adhesive dots 50 on the first surface 11, the projections of the plurality of adhesive dots 50 on the second surface 12 onto the first cell 10 are disposed in a staggered manner from the projections of the plurality of adhesive dots 50 on the first surface 11 onto the first cell 10.

In some embodiments, as shown in FIG. 4, in the first direction K, a distance between an end portion of the first connection line 30 and the first edge 13 of the first cell 10 is greater than or equal to 3 mm and less than or equal to 8.75 mm.

In the embodiments of the present application, as shown in FIG. 4, in the first direction K, the distance between the end portion of the first connection line 30 and the first edge 13 of the first cell 10 is set to be greater than or equal to 3 mm and less than or equal to 8.75 mm. Specifically, the distance between the end portion of the first connection line 30 and the first edge 13 of the first cell 10 may be set to 3 mm, 4 mm, 5 mm, 6 mm, 7 mm, 8 mm, 8.75 mm, or the like.

In the embodiments of the present application, the distance between the end portion of the first connection line 30 and the first edge 13 of the first cell 10 is set to be greater than or equal to 3 mm and less than or equal to 8.75 mm, to avoid a short circuit in the cell string caused by an electrical connection of the first connection line 30 to another connection line because the first connection line 30 is excessively close to the first edge 13 of the first cell 10.

In some embodiments, as shown in FIG. 4, in the first direction K, a distance between the first adhesive dot 51 and the first edge 13 is a third distance, and a distance between an end portion of the first connection line 30 and the first edge 13 is a fourth distance; and a difference between the third distance and the fourth distance is greater than or equal to 2 mm.

In the embodiments of the present application, as shown in FIG. 4, in the first direction K, the distance between the first adhesive dot 51 and the first edge 13 is set as the third distance, and the distance between the end portion of the first connection line 30 close to the first edge 13 and the first edge 13 is set as the fourth distance. A difference between the third distance and the fourth distance is greater than or equal to 2 mm.

For example, the difference between the third distance and the fourth distance may be 2 mm, 2.2 mm, 2.5 mm, 2.7 mm, 3 mm, 3.3 mm, or the like.

In the embodiments of the present application, the difference between the third distance, which is between the first adhesive dot 51 and the first edge 13, and the fourth distance, which is between the end portion of the first connection line 30 close to the first edge 13 and the first edge 13, is set to be greater than or equal to 2 mm, to avoid a short circuit in the cell string because the end portion of the first connection line 30 is excessively close to the first edge 13.

In some embodiments, as shown in FIG. 1 to FIG. 4, in the first direction K, a distance between the finger 20 and the first edge 13 is 0.75 mm.

In the embodiments of the present application, as shown in FIG. 1 to FIG. 4, in the first direction K, a distance between the finger 20 close to the first edge 13 and the first edge 13 is set to 0.75 mm, to facilitate the arrangement of the first terminal line 40 and the first bold section 60 between the end portion of the first terminal line 40 close to the first edge 13 and the finger 20.

In some embodiments, in a second direction H, lengths of the first cell 10 and the second cell are greater than or equal to 180 mm and less than or equal to 240 mm.

In the embodiments of the present application, the lengths of the first cell 10 and the second cell in the second direction H are greater than or equal to 180 mm and less than or equal to 240 mm. For example, along the second direction H, the lengths of the first cell 10 and the second cell may be 180 mm, 182 mm, 191.6 mm, 191.75 mm, 192 mm, 210 mm, 220 mm, 230 mm, 240 mm, or the like.

In some embodiments, the first cell 10 and the second cell may be rectangular structures. Specific dimensions of the first cell 10 and the second cell of the rectangular structures include: (182±2) mm*(96±1) mm, (192±2) mm*(91±1) mm, (182±2) mm*(91±1) mm, (182±2) mm*(105±1) mm, and the like.

Certainly, in the embodiments of the present application, specific structures and specific dimensions of the first cell 10 and the second cell are not limited, and a first cell 10 and a second cell having any structure and any dimension shall fall within the scope of protection of the present application. During actual use, a skilled person may select suitable cells as required as the first cell 10 and the second cell.

The present application provides a cell string. The cell string includes a first connection line, a first cell, and a second cell, the first cell and the second cell being electrically connected by the first connection line. The first connection line extends along a first direction on a first surface of the first cell. The first cell is provided with a first edge and a second edge that are opposite in the first direction. A first terminal line extending along the first direction is disposed on the first surface of the first cell. The first terminal line is close to the first edge and away from the second edge. A portion of the first connection line extends onto the first terminal line to form an overlapping portion. A length of the overlapping portion accounts for 40% to 80% of a length of the first terminal line. In the cell string in the embodiments of the present application, the first terminal line extending along the first direction is disposed on the first surface of the first cell, and the first terminal line is close to the first edge of the first cell and away from the second edge. The first connection line extends along the first direction on the first surface of the first cell. A portion of the first connection line extends onto the first terminal line to form an overlapping portion. A length of the overlapping portion accounts for 40% to 80% of a length of the first terminal line. Therefore, the current generated in a region of the first cell close to the first edge may be collected using the first terminal line, thereby improving the photoelectric conversion efficiency of the cell.

FIG. 7 is a cross-sectional view 1 of a photovoltaic module according to an embodiment of the present application. FIG. 8 is a cross-sectional view 2 of a photovoltaic module according to an embodiment of the present application.

As shown in FIG. 7 and FIG. 8, embodiments of the present application further provide a photovoltaic module, including a cover plate 70, a first adhesive layer 71, a plurality of cell strings in the foregoing embodiments, a second adhesive layer, and a back sheet that are disposed in sequence. The plurality of cell strings are arranged at intervals.

As shown in FIG. 7 and FIG. 8, the embodiments of the present application further provide the photovoltaic module. The photovoltaic module includes a plurality of cell strings in the foregoing embodiments. The plurality of cell strings are arranged at intervals.

The cover plate 70 is connected to one side of the cell strings by the first adhesive layer 71, and the back sheet is connected to the other side of the cell strings by the second adhesive layer.

It should be noted that in the embodiments of the present application, the structure of the cell strings included in the photovoltaic module is the same as that of the cell strings in the foregoing embodiments, and the beneficial effects thereof are also similar. Details are not described herein again.

In some embodiments, as shown in FIG. 7 and FIG. 8, the first adhesive layer 71 and/or the second adhesive layer are multi-layer composite adhesive layers.

As shown in FIG. 7 and FIG. 8, the first adhesive layer 71 and/or the second adhesive layer in the embodiments of the present application are multi-layer composite adhesive layers. The multi-layer composite adhesive layers may include an EVA layer and a POE layer.

The EVA layer is an ethylene-vinyl acetate copolymer layer, and has processing characteristics of being water-resistant, corrosion-resistant, and easy to perform hot pressing, cutting, pasting, and conforming. The POE layer is a high polymer layer of ethylene and octylene, or a high polymer layer of ethylene and butylene.

In some embodiments, as shown in FIG. 7, the multi-layer composite adhesive layer is a double-layer structure, including an EVA layer 711 and a POE layer 712 that are stacked in sequence.

As shown in FIG. 7, the multi-layer composite adhesive layer is a double-layer structure, including an EVA layer 711 and a POE layer 712 that are stacked in sequence. The EVA layer 711 is connected to the cell strings. The EVA layer 711 is easy to perform hot pressing, to perform hot pressing and forming on the photovoltaic module through hot pressing.

In some embodiments, as shown in FIG. 8, the multi-layer composite adhesive layer is a three-layer structure, including an EVA layer 711, a POE layer 712, and an EVA layer 711 that are stacked in sequence.

As shown in FIG. 8, the multi-layer composite adhesive layer is a three-layer structure, including an EVA layer 711, a POE layer 712, and an EVA layer 711 that are stacked in sequence. One of the EVA layers 711 is connected to the cell strings, and the other EVA layer 711 is connected to the cover plate 70 or the back sheet. Through hot pressing, the cover plate 70 is connected to one side of the cell strings by the multi-layer composite adhesive layer, and the back sheet is connected to the other side of the cell strings by the multi-layer composite adhesive layer.

The foregoing described device embodiments are merely examples. The units described as separate parts may or may not be physically separate, and the parts displayed as units may or may not be physical units, may be located in one position, or may be distributed on a plurality of network units. Some or all of the modules may be selected according to actual needs to achieve the objectives of the solutions in the embodiments. A person of ordinary skill in the art can understand and implement the solutions without creative efforts.

"One embodiment", "embodiment", or "one or more embodiments" mentioned in this specification means that particular features, structures, or characteristics described with reference to the embodiments may be included in at least one embodiment of the present application. In addition, it should be noted that the phrase example herein of "in an embodiment" does not necessarily refer to a same embodiment. Numerous specific details are set forth in the specification provided herein. However, it may be understood that the embodiments of the present application may be practiced without these specific details. In some examples, known methods, structures, and technologies are not disclosed in detail, so as not to mix up understanding on the specification.

In the claims, any reference sign placed between parentheses shall not be construed as limiting the claims. The word "comprise" does not exclude the presence of elements or steps not listed in the claims. A word "a" or "one" before an element does not exclude a plurality of such elements. The present application may be implemented through hardware including different elements and a suitably programmed computer. In the unit claims enumerating several apparatuses, several of these apparatuses can be specifically embodied by the same item of hardware. The use of the words such as "first", "second", "third", and the like does not denote any order. These words can be interpreted as names.

Finally, it should be noted that the foregoing embodiments are merely intended for describing the technical solutions of the present application, but not for limiting the present application. Although the present application is described in detail with reference to the foregoing embodiments, a person of ordinary skill in the art is to understand that modifications may still be made to the technical solutions described in the foregoing embodiments or equivalent replacements may be made to some technical features thereof, provided that such modifications or replacements do not cause the essence of corresponding technical solutions to depart from the spirit and scope of the technical solutions of the embodiments of the present application.

## Claims

1. A cell string, comprising a first connection line, a first cell, and a second cell, the first cell and the second cell being electrically connected by the first connection line, wherein
the first connection line extends along a first direction on a first surface of the first cell, and the first cell is provided with a first edge and a second edge that are opposite in the first direction;
a first terminal line extending along the first direction is disposed on the first surface of the first cell, and the first terminal line is close to the first edge and away from the second edge; and
a portion of the first connection line extends onto the first terminal line to form an overlapping portion, wherein a ratio of a length of the overlapping portion to a length of the first terminal line is less than or equal to 80%.

2. The cell string according to claim 1, wherein the length of the overlapping portion accounts for 40% to 80% of the length of the first terminal line.

3. The cell string according to claim 1, wherein a plurality of first connection lines and a plurality of first terminal lines are provided, and the first connection lines and the first terminal lines are disposed in a one-to-one correspondence.

4. The cell string according to claim 1, wherein a plurality of fingers that extend along a second direction and are disposed at intervals in the first direction are further disposed on the first surface of the first cell, and the second direction intersects the first direction; and
the first terminal line is only connected to some of the plurality of fingers close to the first edge, and the first terminal line is connected to a finger closest to the first edge.

5. The cell string according to claim 4, wherein a bonding layer is provided on the first connection line, and the first connection line is at least connected to some of the fingers by the bonding layer.

6. The cell string according to claim 1, wherein the first connection line is fixed to the first surface of the first cell by a plurality of discrete adhesive dots.

7. The cell string according to claim 1, wherein the length of the first terminal line is less than 1/4 of a length of a projection of the first connection line onto the first cell.

8. The cell string according to claim 1, wherein the first surface of the first cell further comprises a second terminal line close to the second edge, and the second terminal line is entirely covered by the first connection line.

9. The cell string according to claim 1, wherein in the first direction, a distance between an end portion of the first connection line and the first edge of the first cell is greater than or equal to 3 mm and less than or equal to 8.75 mm.

10. The cell string according to claim 6, wherein only one adhesive dot is disposed on the overlapping portion, and the adhesive dot is a first adhesive dot;
in the first direction, a distance between the first adhesive dot and the first edge is a third distance, and a distance between an end portion of the first connection line and the first edge is a fourth distance; and
a difference between the third distance and the fourth distance is greater than or equal to 2 mm.

11. The cell string according to claim 1, wherein in a second direction, lengths of the first cell and the second cell are greater than or equal to 180 mm and less than or equal to 240 mm.

12. The cell string according to claim 1, wherein dimensions of the first cell and the second cell comprise: (182±2) mm*(96±1) mm, (192±2) mm*(91±1) mm, (182±2) mm*(91±1) mm, and (182±2) mm*(105±1) mm.

13. A cell string, comprising a first connection line, a first cell, and a second cell, the first cell and the second cell being electrically connected by the first connection line, wherein
the first connection line is fixed to a first surface of the first cell by a plurality of discrete adhesive dots, the first connection line extends along a first direction, and the first cell is provided with a first edge and a second edge that are opposite in the first direction;
a first terminal line extending along the first direction is disposed on the first surface of the first cell, and the first terminal line is close to the first edge and away from the second edge; and
a portion of the first connection line extends onto the terminal line to form an overlapping portion, only one adhesive dot is disposed on the overlapping portion, the adhesive dot is a first adhesive dot, a distance between the first adhesive dot and an end portion of the first terminal line close to the first edge is a first distance, a distance between the first adhesive dot and an end portion of the first terminal line away from the first edge is a second distance, and a ratio of the first distance to the second distance ranges from 1:5 to 2:1.

14. The cell string according to claim 13, wherein the first surface of the first cell further comprises a second terminal line close to the second edge, and the second terminal line is entirely covered by the first connection line.

15. The cell string according to claim 14, wherein at least one adhesive dot is disposed on the second terminal line.

16. The cell string according to any one of claims 13 to 15, wherein two ends of the first terminal line are connected to two fingers, respectively, a first bold section is disposed at a connection to each of the two fingers, and the first terminal line is electrically connected to the fingers by the first bold section.

17. The cell string according to claim 13, wherein the first cell further comprises a second surface disposed opposite to the first surface, and the cell string further comprises a second connection line connected to the second surface;
the second connection line is connected to the second surface of the first cell by a plurality of discrete adhesive dots; and
projections of the plurality of adhesive dots on the first surface onto the first cell are disposed in a staggered manner from projections of the plurality of adhesive dots on the second surface onto the first cell.

18. The cell string according to claim 13, wherein in the first direction, a distance between the first adhesive dot and the first edge is a third distance, and a distance between an end portion of the first connection line and the first edge is a fourth distance; and
a difference between the third distance and the fourth distance is greater than or equal to 2 mm.

19. A photovoltaic module, comprising a cover plate, a first adhesive layer, a plurality of cell strings according to any one of claims 1 to 18, a second adhesive layer, and a back sheet that are disposed in sequence, and the plurality of cell strings are arranged at intervals.
